(19) **Europäisches Patentamt / European Patent Office / Office européen des brevets**

(11) **EP 4 779 403 A1**

(12) # EUROPEAN PATENT APPLICATION

(43) Date of publication:
**22.07.2026 Bulletin 2026/30**

(51) International Patent Classification (IPC):
***G03F 7/00*** *(2006.01)*

(21) Application number: **25152911.1**

(52) Cooperative Patent Classification (CPC):
**G03F 7/70116; G03F 7/70525; G03F 7/70583**

(22) Date of filing: **20.01.2025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
- **DE JONG, Edwin**
  **5500 AH Veldhoven (NL)**
- **KRIETE, Bjorn**
  **5500 AH Veldhoven (NL)**
- **EVERTS, Frank**
  **5500 AH Veldhoven (NL)**
- **VAN VEEN, Marieke, Katherine**
  **5500 AH Veldhoven (NL)**

(74) Representative: **ASML Netherlands B.V.**
**Corporate Intellectual Property**
**P.O. Box 324**
**5500 AH Veldhoven (NL)**

(54) ## METHOD OF FORMING AN ILLUMINATION MODE, METHOD OF EXPOSING A SUBSTRATE AND ILLUMINATION SYSTEM

(57) A method of forming an illumination mode using an illumination system comprising an array of individually controllable reflective elements arranged to direct portions of a radiation beam to desired locations in a pupil plane. The method comprises allocating different reflective elements of the array to direct radiation to different locations in the illumination mode by: determining a desired power spectral density function of radiation directed by the array of reflective elements to the illumination mode, the desired power spectral density function including a cutoff frequency; applying different phases to frequency components of the power spectral density function; transforming the power spectral density function into a spatial domain signal that varies as a function of positions of the reflective elements; and using the spatial domain signal to allocate reflective elements that direct radiation to different locations in the illumination mode.

Fig. 4

Processed by Luminess, 75001 PARIS (FR)

**Description**

<u>FIELD</u>

The present invention relates to a method forming a desired illumination mode. The method may be performed in a lithographic apparatus.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

An illumination system of a lithographic apparatus may be used to form a desired illumination mode. The term 'illumination mode' refers to a spatial distribution of exposure radiation in a pupil plane prior to the radiation being incident upon a patterning device. Properties of the illumination mode will affect a pattern that is exposed on a substrate by the lithographic apparatus.

It may be desirable to form an illumination mode using a method not taught or suggested by the prior art.

<u>SUMMARY</u>

According to a first aspect of the invention there is provided a method of forming an illumination mode using an illumination system comprising an array of individually controllable reflective elements arranged to direct portions of a radiation beam to desired locations in a pupil plane; wherein the method comprises allocating different reflective elements of the array to direct radiation to different locations in the illumination mode by: determining a desired power spectral density function of radiation directed by the array of reflective elements to the illumination mode, the desired power spectral density function including a cutoff frequency; applying different phases to frequency components of the power spectral density function; transforming the power spectral density function into a spatial domain signal that varies as a function of positions of the reflective elements; and using the spatial domain signal to allocate reflective elements that direct radiation to different locations in the illumination mode.

Advantageously, the method allows for suppression of undesired frequencies. Suppression of low frequencies is particularly advantageous, for example, because this suppression reduces undesirable low frequency effects in images formed at the lithographic substrate.

The illumination mode may comprise a plurality of spatially separated illuminated areas, and wherein the different locations to which radiation is directed correspond with the spatially separated illuminated areas.

The spatially separated illuminated areas of the illumination mode may be poles.

The illumination mode may be a quadrupole mode.

The power spectral density function may include a low frequency cutoff.

A coherence size may be used to determine the low frequency cutoff of the power spectral density function.

The power spectral density function may include an additional and different low frequency cutoff used for reflective element allocation in an orthogonal direction on the array of reflective elements.

The low frequency cutoff may correspond with a spatial dimension of 4 mm or less.

The power spectral density function may include a high frequency cutoff.

Transforming the power spectral density function into the spatial domain signal may be performed using an inverse Fourier transform.

The different phases applied to the frequency components may be random phases.

According to a second aspect of the invention there is provided a method of exposing a substrate using a lithographic apparatus, the method comprising providing a beam of radiation using an illumination system; using the method of the first aspect to form an illumination mode using the beam of radiation; directing the beam of radiation with the illumination mode onto a patterning device to impart the radiation beam with a pattern in its cross-section; and projecting the patterned radiation beam onto a target portion of a substrate.

According to a third aspect of the invention there is provided an illumination system comprising an array of individually controllable reflective elements arranged to direct portions of a radiation beam to desired locations in a pupil plane, and further comprising a processor, wherein the processor is configured to allocate different reflective elements of the array to direct radiation to different locations in an illumination mode by determining a desired power spectral density function of radiation directed by the array of reflective elements to the illumination mode, the desired power spectral density function including a cutoff frequency; applying different phases to frequency components of the power spectral density function; transforming the power spectral density function into a spatial domain signal that varies as a function of positions of the reflective elements; and using the spatial domain signal to allocate reflective elements that direct radiation to different locations in the illumination mode.

Advantageously, the illumination system is able to suppress undesired frequencies. Suppression of low frequencies is particularly advantageous, for example, because this suppression reduces undesirable low frequency effects in images formed at the lithographic substrate.

The illumination mode may comprise a plurality of spatially separated illuminated areas, and wherein the different locations to which radiation is directed correspond with the spatially separated illuminated areas.

The spatially separated illuminated areas of the illumination mode may be poles.

The illumination mode may be a quadrupole mode.

The power spectral density function may include a low frequency cutoff.

A coherence size may be used to determine the low frequency cutoff of the power spectral density function.

The power spectral density function may include an additional and different low frequency cutoff used for reflective element allocation in an orthogonal direction on the array of reflective elements.

The low frequency cutoff may correspond with a spatial dimension of 4 mm or less.

Features of different aspects of the invention may be combined together.

BRIEF DESCRIPTION OF THE DRAWINGS

Embodiments of the invention will now be described, by way of example only, with reference to the accompanying schematic drawings, in which:

- Figure 1 schematically depicts a lithographic apparatus;
- Figure 2 schematically depicts operation of an array of individually controllable reflective elements, which forms part of an illumination system of the lithographic apparatus;
- Figure 3 schematically depicts a quadrupole illumination mode formed using the array of individually controllable reflective elements;
- Figure 4 is a chart depicting a power spectral density function used by an embodiment of the invention;
- Figure 5 schematically depicts spatial frequency components for an array of mirrors, which may form part of an embodiment of the invention;
- Figure 6 depicts a mirror allocation scheme obtained using a method according to an embodiment of the invention for the power spectral density function depicted in Figure 4;
- Figure 7 depicts an alternative mirror allocation scheme obtained using the method according to an embodiment of the invention for the power spectral density function depicted in Figure 4;
- Figure 8 is a chart depicting an alternative power spectral density function used by an embodiment of the invention; and
- Figure 9 depicts a mirror allocation scheme obtained using a method according to an embodiment of the invention for the power spectral density function depicted in Figure 8.

DETAILED DESCRIPTION

In the present document, the terms "radiation" and "beam" are used to encompass all types of electromagnetic radiation, including ultraviolet radiation (e.g., with a wavelength of 365, 248, 193, 157 or 126 nm) and EUV (extreme ultra-violet radiation, e.g., having a wavelength in the range of about 5-100 nm). The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

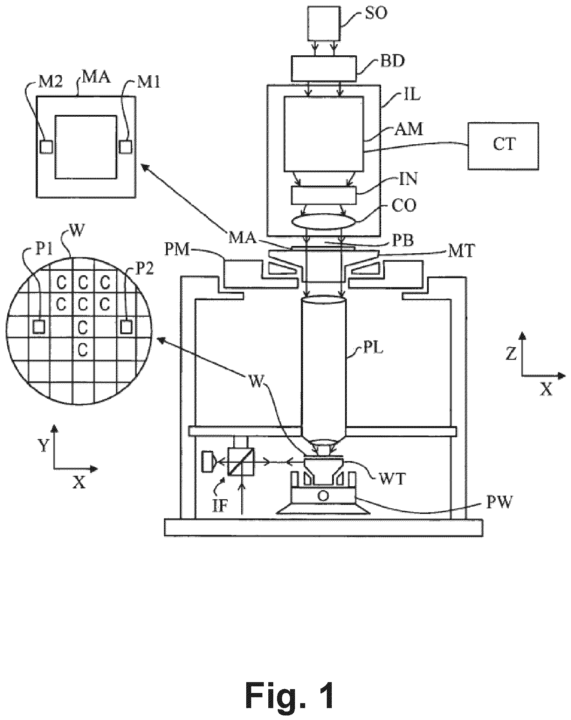

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g., via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illumination system IL may be used to condition the radiation beam B to have a desired spatial and angular intensity distribution in its cross section at a plane of the patterning device MA. The illumination system IL may be used to form a desired illumination mode in a pupil plane of the lithographic apparatus.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g., mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

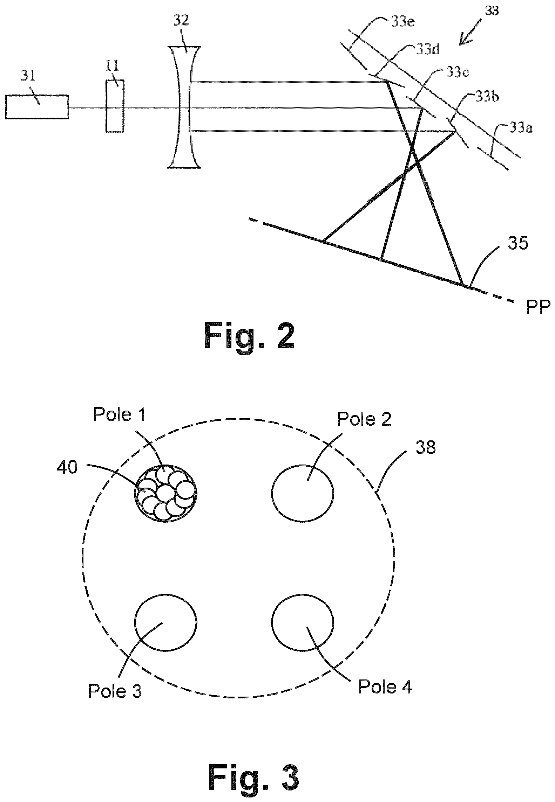

The illumination system IL may be used to form a desired illumination mode in a pupil plane PP of the lithographic apparatus, as schematically depicted in Figure 2. A source 31 (equivalent to SO in FIG. 1) outputs a relatively narrow, collimated radiation beam which passes through a shutter 11. The radiation beam then passes through beam divergence optics 32, which expand the beam to a size that corresponds to the size of an array 33 of mirrors 33a-e. Ideally, the radiation beam divergence optics 32 should output a collimated beam. Preferably, the size of the expanded radiation beam generally corresponds with the size of the array 33 of mirrors. For example, the size of the radiation beam may be sufficient that the radiation beam is incident at substantially all mirrors 33a-e. The array 33 of mirrors may be a two-dimensional array. The arrangement depicted in Figure 2 is merely an example. In other examples, the source 31 may provide a beam, which is not narrow and/or collimated, and the shutter 11 may be absent. In general, optics may be provided which generally collimate the radiation beam before it is incident upon the array 33 of mirrors.

In FIG. 2, by way of example, three sub-beams of the radiation beam are shown. A first sub-beam is incident at mirror 33b. Like the other mirrors 33a-e of the array 33, the mirror 33b can be controlled to adjust its orientation so that the sub-beam is reflected in a desired predetermined direction. The sub-beam is incident at a mirror 35, which is located in a pupil plane PP of the lithographic apparatus. The other sub-beams shown in FIG. 2 are reflected by the mirrors 33c, 33d and are incident at other points in the pupil plane PP. By controlling the orientations of the mirrors 33a to 33e, almost any spatial intensity distribution in the pupil plane PP can be produced. In other words, almost any desired illumination mode may be formed. In some embodiments there is no mirror at the pupil plane PP. A mirror may instead be located further downstream from the pupil plane PP.

Although FIG. 2 shows only five mirrors 33a-e, the array 33 may include many more mirrors, for example arranged in a two-dimensional grid. For example, the array 33 may include 1024 (e.g., $32\times32$) mirrors, or 4096 (e.g., $64\times64$) mirrors, or any other suitable number of mirrors. An array of $m\times n$ mirrors, where m is an integer and n is an integer, may be used (e.g., with m=n or m≠n). The array may for example comprise m mirrors along one direction, where m = $2^k$ (k being an integer), and may for example comprise n mirrors along an orthogonal direction, where n = $2^j$ (j being an integer). More than one array of mirrors may be used. For example a group of four mirror arrays having $32\times32$ mirrors each may be used. In the following text, the term 'array' may mean a single array or a group of mirror arrays.

The orientation of each mirror of the array 33 may be adjusted separately. The orientations of the mirrors may be controlled by a controller CT (see FIG. 1).

Figure 3 schematically depicts a quadrupole illumination mode (referred to hereafter as a quadrupole mode). The quadrupole mode comprises four areas of radiation, which are separated from one another and are located adjacent a numerical aperture perimeter 38 of the illumination system (the areas of radiation are within the numerical aperture). Each area of radiation is referred to as a pole (poles 1-4). Each pole of radiation is formed by orienting mirrors of the array 33 depicted in Figure 2 to direct radiation to that pole. Pole 1 is schematically depicted as being formed by areas of radiation 40. Although only a small number of areas of radiation 40 are depicted, in practice many more areas of radiation may be used to form the pole (e.g., 50 areas of radiation or more). Poles 2-4 are formed in the same way.

An embodiment of the invention may determine which mirrors of the array 33 are used to direct radiation to each of Poles 1-4 of a quadrupole mode. An embodiment of the invention allows a spatial frequency of mirrors that direct radiation to each of Poles 1-4 to be selected or controlled. Other embodiments may determine, which mirrors 33a-e of the array 33 are used to direct radiation to parts of other illumination modes (and may allow selection or control of spatial frequencies of those mirrors).

An embodiment of the invention provides a method of determining allocation of mirrors of an array of individually controllable mirrors in a manner, which provides control of a distribution of the mirrors that contribute to each pole of the quadrupole mode. In other words, the method provides control of spatial frequencies present in a distribution of mirrors of the reflective array, which contributes to the quadrupole illumination mode.

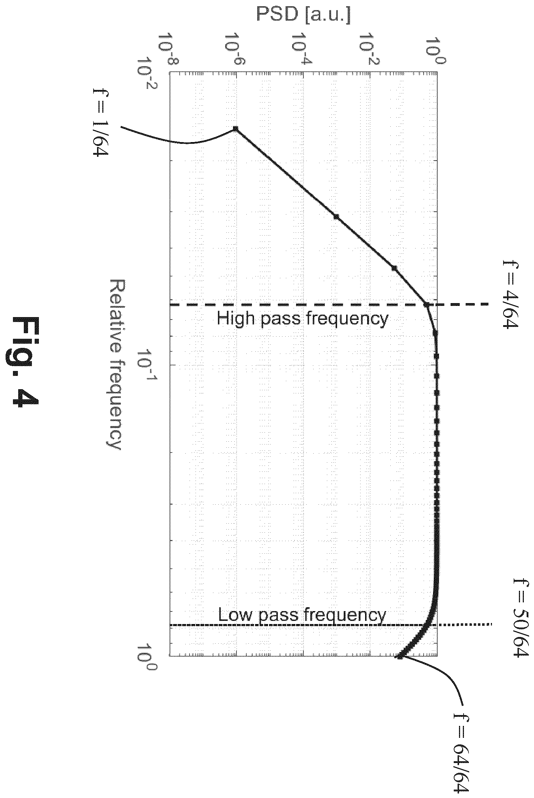

A first part of the method comprises establishing a desired power spectral density (PSD) for the spatial frequencies of the mirrors, which direct radiation to each pole of the quadrupole mode. An example of a desired power spectral density is depicted in Figure 4. In this example, which is provided for illustrative purposes, the array is a 1 x 64 array of mirrors. A minimum frequency corresponds with a maximum spatial wavelength of the radiation at the mirror array. That is, a frequency of 1/64 (which may be referred to as a relative frequency of 1/64). A maximum frequency corresponds with a minimum spatial wavelength of the radiation at the mirror array. That is, a frequency of 64/64, i.e., a frequency of 1 (which may be referred to as a relative frequency of 1).

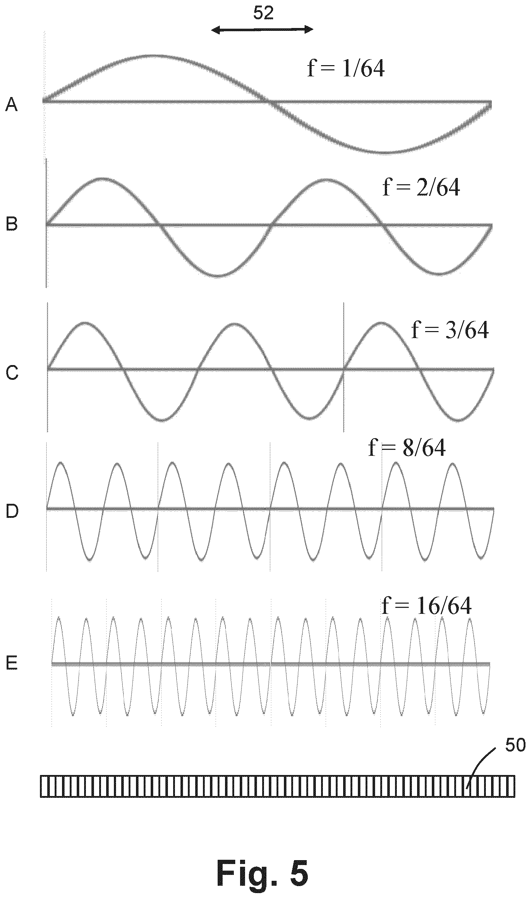

Examples of spatial wavelengths and associated spatial frequencies are schematically depicted in Figure 5. A 1 x 64 micro mirror array 50 is depicted at the bottom of Figure 5, as an example. A single wavelength, which has a length corresponding with a length of the mirror array 50, is depicted as chart A. In this example the frequency is f = 1/64.

In chart B of Figure 5, the spatial frequency has been doubled to equal 2/64. The length of the micro mirror array 50 corresponds with two wavelengths. In chart C the frequency is 3/64, meaning that three wavelengths fit on the array 50. In chart D the frequency is 8/64 meaning that eight wavelengths fit on the array 50. In chart E the frequency is 16/64, meaning that sixteen wavelengths fit on the array 50. Although a selection of frequencies is shown in Figure 5, the micro mirror array 50 is capable of providing every spatial frequency from f=1/64 to f=64/64. That is, for a given pole the mirrors of the micro mirror array 50, which point towards that pole, may have any spatial frequency from f=1/64 to f=64/64. The mirrors of the micro mirror array 50, which point towards the pole, may have a combination of spatial frequencies from f=1/64 to f=64/64. In general, the frequency ranges from 1/N to N/N, with N being an integer. Preferably N=$2^k$, with k being an integer.

Referring again to Figure 4, the power spectral density indicates the relative amplitude of each spatial frequency component of a distribution of mirrors pointing at a given quadrupole mode (i.e., the relative amplitudes of the frequency components schematically depicted in part in Figure 5). The amplitude is a relative amplitude expressed in arbitrary units. The frequency is expressed as a relative frequency, the right hand end of the chart being a frequency of 1. The scales of the chart are logarithmic.

The power spectral density may be defined by a function, which provides a bandpass characteristic:

$$PSD(f; b, c) = 1 - \frac{1}{1 + \left(\frac{b}{f}\right)^c}$$

$$PSD_{BP}(f) = PSD(f; b_1, c_1) \cdot PSD(f; b_2, -c_2)$$

where $b_1$ is the cutoff frequency of the bandpass at low frequencies and $c_1$ determines how quickly frequencies below the cutoff frequency are dampened (the slope of roll-off at low frequencies), and where $b_2$ is the cutoff frequency of the bandpass at high frequencies and $-c_2$ determines how quickly frequencies above the cutoff frequency are dampened (the slope of roll-off at high frequencies). Although not in the above power spectral density, the power spectral density may include an amplitude term.

The power spectral density depicted in Figure 4 was generated using the above function, with a cutoff frequency at low frequencies of 4/64 ($b_1$ = 4/64) and a cutoff frequency at high frequencies of 50/64. The cutoff frequency of 4/64 is labelled as a high pass frequency, indicated by a dashed line, because the filter passes frequencies above this cutoff frequency. The cutoff frequency of 50/64 ($b_2$ = 50/64) is labelled as a low pass frequency, indicated by a dotted line, because the filter passes frequencies below this cutoff frequency. In the power spectral density depicted in Figure 4, the roll-off parameter is 10 (i.e., $c_1$ = 10 and $c_2$ = 10).

As depicted in Figure 4, in the power spectral density the lowest frequencies are suppressed. In addition, the highest frequencies are suppressed.

Suppression of the lowest frequencies is particularly advantageous because this suppression reduces undesirable low frequency effects in images formed at the lithographic substrate. In other words, low frequency wavy lines which may be formed in an image on a substrate may be suppressed (i.e., the wavy lines may be not formed or may be formed with a reduced amplitude). These low frequency wavy lines may be due to spatial coherence of the radiation used to form images. The radiation, when incident at the mirror array, may include areas of spatial coherence which are referred to herein as coherence cells. The coherence cells may for example extend over several mirrors of the mirror array (e.g., around 4 mirrors). If the mirrors of a given coherence cell all direct radiation to a particular pole of the quadrupole mode, then the spatial coherence of the coherence cell is retained and this may generate undesirable wavy lines in an image. This is because the illumination mode for that specific coherence cell is very limited in size, and as a result the coherence cell fully consists of low frequency content. This low frequency content generates the undesirable low frequency wavy lines in the image.

If the mirrors of the coherence cell direct radiation to different poles of the quadrupole mode, then a substantial part of the low-frequency content is sent to the high-frequency domain. The high frequency content does not generate low frequency wavy lines in the image. High frequency wavy lines may be generated, but high frequency wavy lines are removed or suppressed during processing of the substrate (unlike low frequency wavy lines).

Although the effect of the invention is described above in connection with a quadrupole mode, the same effect applies for other illumination modes. In general, an embodiment of the invention may have an illumination mode with a plurality of spatially separated illuminated areas (e.g., separated by dark unilluminated areas). Radiation from a coherence cell may be directed to locations, which lie in different spatially separated illuminated areas. The spatially separated illuminated areas of the illumination mode may be poles.

The power spectral density function of Figure 4 suppresses low frequencies of the spatial frequency component of a distribution of mirrors pointing at a given quadrupole mode. In other words, the power spectral density function of Figure 4 reduces the probability of mirrors with a separation of 4 mirrors or less all pointing at the same pole of the quadrupole mode.

In an embodiment, mirror orientation allocations are determined using a power spectral density with the following method:

- Each of the spatial frequencies of mirror orientation, which may be present at the $1 \times 64$ mirror array, is provided with an amplitude according to a desired power spectral density. Referring to Figure 5, this means that the amplitude of each depicted frequency (and other frequencies not depicted) is applied. In the case of the power spectral density of Figure 4, the amplitude of f=1/64 is strongly suppressed, the amplitude of f=2/64 also suppressed, etc.

- The square root of each amplitude for each frequency is obtained to obtain a set of frequency components.

- Different phases (e.g., between $-\pi$ and $\pi$) are applied to different frequency components. For example, random phases (including pseudo-random phases) may be applied. Referring to Figure 5, this is schematically indicated by the double-headed arrow 52. Applying a random phase to each frequency component corresponds with translating each sinewave to the left or right by a random amount. Each of the frequency components along with their associated phases form a frequency domain signal.

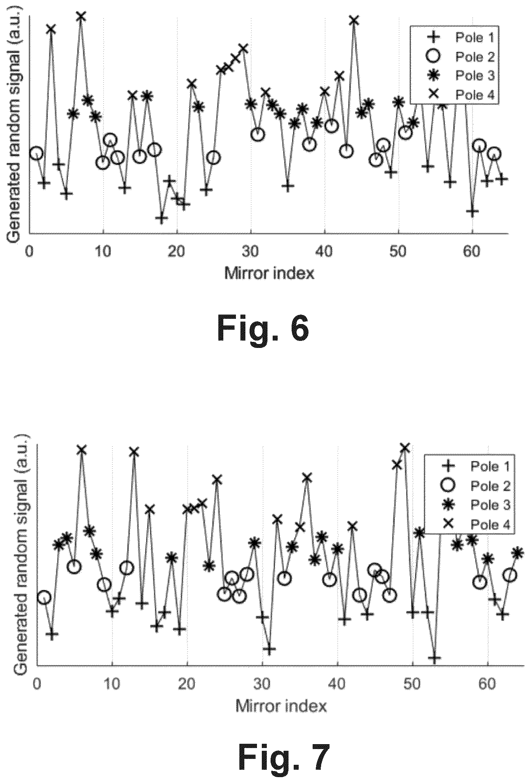

- An inverse Fourier transform is used to convert the frequency domain signal into a spatial domain signal. That is, a signal that varies as a function of position on the $1 \times 64$ micro mirror array. An example of the spatial domain signal is depicted in Figure 6. Although the spatial domain signal may appear to be random with no particular frequency distribution, the spatial domain signal includes a reduced amount of low frequency components..

- The spatial domain signal is used to allocate mirrors to each pole of the quadrupole, as indicated. In this example, data points of the spatial domain signal with the lowest vertical axis value are allocated to the first pole. Since there are 64 mirrors in this example, the 16 mirrors associated with the lowest values are allocated to the first pole. The 16 mirrors associated with the lowest remaining values are allocated to the second pole. The 16 mirrors associated with the lowest remaining values are allocated to the third pole. There are then 16 remaining mirrors (they are the mirrors with the highest values). These are allocated to the fourth pole. Because the power spectral density depicted in Figure 4 was used, allocation of mirrors to each of the poles of the quadrupole mode is provided using a spatial domain signal in which low spatial frequencies are suppressed. From looking at Figure 6 it can be seen that there are only two instances in which four mirrors all point to the same pole (mirrors 18-21 point to pole 1, and mirrors 25-29 point to pole 4), and there are no instances in which five or more mirrors point to the same pole.

The random allocation of phases to each frequency component means that running the same method again will provide a different mirror orientation allocation. To illustrate this, the method was run again using the same power spectral density parameters, i.e., $b_1 = 4/64$, $b_2 = 50/64$, $c_1 = 10$, $c_2 = 10$. The spatial domain signal obtained by running the method again is depicted in Figure 7. Again, low frequency components of the mirror orientation can be seen to be suppressed. There is only one instance in which four mirrors all point to the same pole (mirrors 25-28 point to pole 2), and there are no instances in which five or more mirrors point to the same pole.

Running the same method again will generate a different mirror orientation allocation if different phases (e.g., random phases) are applied to the frequencies. Low spatial frequencies will again be suppressed in the mirror allocation. If the phases used for the frequencies are not changed then the same mirror allocation will be generated by the method.

A mirror allocation generated for one lithographic apparatus may be used for another lithographic apparatus. However, there may be differences between the lithographic apparatuses, such as variations of mirror reflectivity or variations of incident light intensity. If there are differences between lithographic apparatuses then it may be preferable to generate a new mirror allocation.

A method according to an embodiment of the invention may be used to apply any desired power spectral density to the allocation of mirror orientations. The desired power spectral density may be selected based upon desired properties of images formed at a substrate by the lithographic apparatus. For example, it may be desirable to supress low frequency modulations in images (low frequency wavy lines) and this may be achieved by suppressing low frequencies in the mirror allocations as explained above. Higher frequency modulations in an image may be acceptable in some cases because the higher frequency modulations may be removed during processing of the substrate after it has been exposed by the radiation.

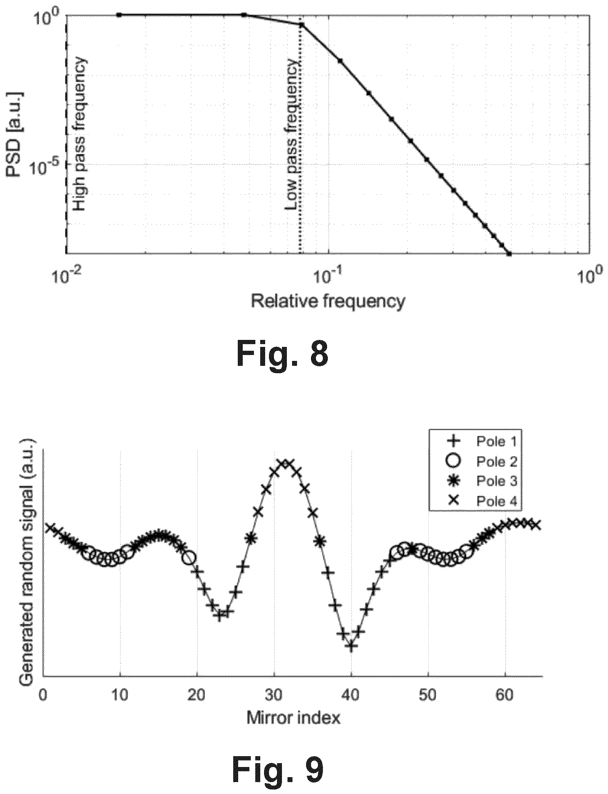

In another example it may be desirable to suppress high frequency modulations. A power spectral density, which suppresses high frequency mirror allocations, is depicted in Figure 8. In this case there is a high frequency cutoff at $b_1 = 4/64$ with the roll-off being $c_1 = 10$. There is no low frequency cutoff. With this power spectral density the higher frequencies are suppressed. This may be useful if there is a particularly undesirable high frequency intensity variation of radiation. In one example, a high frequency intensity variation may be caused by variation of beam pointing from the radiation source to the illumination system. This undesired high frequency intensity variation may be suppressed via selection of a power spectral density which suppresses high frequencies. The intensity variation may be suppressed via selection of a power spectral density, which suppresses the frequency or frequencies of the intensity variation.

Figure 9 depicts a spatial domain signal obtained using the power spectral density of Figure 8. As can be seen, the spatial domain signal does not contain high frequency components, but instead contains only low frequencies (the spatial domain signal varies slowly as a function of spatial position). Allocation of poles using the spatial domain signal is shown. In this case, the lowermost 16 values of the spatial domain signal are clustered in two groups. Thus, two groups of mirrors direct radiation to the first pole. There are four groups of mirrors directing radiation to the second pole. Two of the groups of mirrors are quite large (6 mirrors and 7 mirrors), but two groups are small (2 mirrors and 1 mirror). The third and fourth poles of the mode are also formed predominantly from mirrors in large groups.

As noted above, the power spectral density function can be selected as desired to suppress unwanted frequency components in a mirror allocation for an illumination mode.

For simplicity the above examples are explained in relation to a $1 \times 64$ array of mirrors. In practice the array of mirrors may be a 2-dimensional array (e.g., $32 \times 32$ mirrors, $64 \times 64$ mirrors, or some other size). The method can be extended to 2-dimensions for a 2-dimensional array. In 2D, the power spectral density can accept multiple frequencies that account for the different spatial directions of the array, for example the horizontal and the vertical directions. The power spectral density can be selected to suppress horizontal and vertical frequencies differently. This allows for more detailed tuning of the frequencies present in patterns exposed on a substrate. Random phases may be applied for each frequency combination. Transformation from the frequency to the spatial domain may be performed using a 2D inverse Fourier transform.

In the above embodiments the frequency domain signal is transformed to the spatial domain using an inverse Fourier transform. However, any suitable transform from the frequency domain to the spatial domain may be used.

In the above embodiments the illumination mode is a quadrupole mode. However, embodiments of the invention may be used in connection with any illumination mode.

The application of different (e.g., random) phases to the frequency components before transforming to the spatial domain advantageously avoids introducing undesirable frequency components, which may otherwise be present. Thus, embodiments of the invention allow suppression of undesired frequency components, whilst avoiding accidental introduction of frequency components that could arise for example if a repeating pattern of mirror allocations were to be used.

In an embodiment, the spatial coherence of radiation may be defined in terms of a coherence size $\rho_{coh}$, being the maximum distance over which coherence exists in the radiation. The coherence cell may be a disk with a diameter corresponding with the coherence size $\rho_{coh}$. In a lithographic apparatus, the coherence size $\rho_{coh}$, is determined at least in part by properties of the source SO, 31, which may be a laser. The coherence size $\rho_{coh}$ of the radiation beam at the micro mirror array may be used to determine the power spectral density function that is used to determine the mirror allocation. For example, the cutoff frequency below which low frequencies are suppressed may be selected with reference to the coherence size $\rho_{coh}$. In one example, the micro mirror array comprises $64 \times 64$ mirrors and measures $5 \times 5$ cm$^2$. In this example, each mirror may be square with a length of 0.78 mm. The coherence size $\rho_{coh}$ of the radiation beam at the mirror array may be around 3 mm, which corresponds with slightly less than 4 mirrors. The low frequency cutoff for the power spectral density function may be set at 4/64. In general, the low frequency cutoff of the power spectral density function may be set at a value, which corresponds to a distance greater than the coherence size $\rho_{coh}$ of the radiation at the micro mirror array.

It may be possible to measure the coherence size $\rho_{coh}$ of the radiation beam at the micro mirror array by removing the micro mirror array and replacing it with an image sensor. The image sensor may be used to obtain an image for a single pulse of incident radiation. This image will include intensity fluctuations due to coherence effects. The spatial size of the intensity fluctuations may correspond with the coherence size $\rho_{coh}$. Multiple images may be used when measuring the coherence size $\rho_{coh}$.

Alternatively, a series of substrate exposures may be performed with mirrors allocated using different power spectral density functions, and modulations present in the exposed substrates may be used to determine the coherence size $\rho_{coh}$ of the radiation beam.

In an alternative approach, a series of substrate exposures may be performed with the low frequency cutoff being increased gradually until undesired low frequency modulations are no longer present in exposed images or have a negligible contribution.

In an embodiment, the coherence cell may be non-circular. For example, the coherence cell may be elliptical. An elliptical coherence cell may be caused for example due to properties of a laser SO, 31 used to generate the radiation beam. Where this is the case, a two dimensional power density function used to determine mirror allocation may include different cutoff frequencies in the first and second directions. The cutoff frequencies may be selected for example through knowledge of the shape and size of coherence cells of the radiation. The cutoff frequencies may be selected for example through generating a series of exposures with mirrors allocated using different power spectral density functions in each dimension, and selecting power spectral density functions which provide desired image properties (e.g., no low frequency modulations or low frequency modulations below a desired threshold).

A mirror allocation for an illumination mode may be determined according to an embodiment of the invention and then used during exposure of substrates by a lithographic apparatus. The illumination mode may be modified, for example to improve imaging performance. When the illumination mode is modified, a new mirror allocation may be determined according to an embodiment of the invention, and then used during exposure of subsequent substrates by the lithographic apparatus.

As explained further above, the orientations of the mirrors may be controlled by a controller CT (see FIG. 1). The controller, which may form part of the illumination system, may include a processor configured to perform a method according to an embodiment of the invention.

Embodiments of the invention are described in terms of mirrors and a mirror array. However, mirrors are merely examples of reflective elements. Other reflective elements may be used.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Embodiments include the following numbered clauses:

1. A method of forming an illumination mode using an illumination system comprising an array of individually controllable reflective elements arranged to direct portions of a radiation beam to desired locations in a pupil plane; wherein the method comprises allocating different reflective elements of the array to direct radiation to different locations in the illumination mode by:

determining a desired power spectral density function of radiation directed by the array of reflective elements to the illumination mode, the desired power spectral density function including a cutoff frequency;
applying different phases to frequency components of the power spectral density function;
transforming the power spectral density function into a spatial domain signal that varies as a function of positions of the reflective elements; and
using the spatial domain signal to allocate reflective elements that direct radiation to different locations in the illumination mode.

2. The method of clause 1, wherein the illumination mode comprises a plurality of spatially separated illuminated areas, and wherein the different locations to which radiation is directed correspond with the spatially separated illuminated areas.

3. The method of clause 2, wherein the spatially separated illuminated areas of the illumination mode are poles.

4. The method of clause 3, wherein the illumination mode is a quadrupole mode.

5. The method of any preceding clause, wherein the power spectral density function includes a low frequency cutoff.

6. The method of clause 5, wherein a coherence size is used to determine the low frequency cutoff of the power spectral density function.

7. The method of clause 5 or clause 6, wherein the power spectral density function includes an additional and different low frequency cutoff used for reflective element allocation in an orthogonal direction on the array of reflective elements.

8. The method of any of clauses 5 to 7, wherein the low frequency cutoff corresponds with a spatial dimension of 4 mm or less.

9. The method of any preceding clause, wherein the power spectral density function includes a high frequency cutoff.

10. The method of any preceding clause, wherein transforming the power spectral density function into the spatial domain signal is performed using an inverse Fourier transform.

11. The method of any preceding clause, wherein the different phases applied to the frequency components are random phases.

12. A method of exposing a substrate using a lithographic apparatus, the method comprising:

providing a beam of radiation using an illumination system;
using the method of clause 1 to form an illumination mode using the beam of radiation;
directing the beam of radiation with the illumination mode onto a patterning device to impart the radiation beam with a pattern in its cross-section; and
projecting the patterned radiation beam onto a target portion of a substrate.

13. An illumination system comprising an array of individually controllable reflective elements arranged to direct portions of a radiation beam to desired locations in a pupil plane, and further comprising a processor, wherein the processor is configured to allocate different reflective elements of the array to direct radiation to different locations in an illumination mode by:

determining a desired power spectral density function of radiation directed by the array of reflective elements to the illumination mode, the desired power spectral density function including a cutoff frequency;
applying different phases to frequency components of the power spectral density function;

transforming the power spectral density function into a spatial domain signal that varies as a function of positions of the reflective elements; and

using the spatial domain signal to allocate reflective elements that direct radiation to different locations in the illumination mode.

14. The illumination system of clause 13, wherein the illumination mode comprises a plurality of spatially separated illuminated areas, and wherein the different locations to which radiation is directed correspond with the spatially separated illuminated areas.
15. The illumination system of clause 14, wherein the spatially separated illuminated areas of the illumination mode are poles.
16. The illumination system of clause 15, wherein the illumination mode is a quadrupole mode
17. The illumination system of any of clauses 13 to 16, wherein the power spectral density function includes a low frequency cutoff.
18. The illumination system of clause 17, wherein a coherence size is used to determine the low frequency cutoff of the power spectral density function.
19. The illumination system of clause 17 or clause 18, wherein the power spectral density function includes an additional and different low frequency cutoff used for reflective element allocation in an orthogonal direction on the array of reflective elements.
20. The illumination system of any of clauses 17 to 19, wherein the low frequency cutoff corresponds with a spatial dimension of 4 mm or less.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method of forming an illumination mode using an illumination system (IL) comprising an array (33,50) of individually controllable reflective elements (33a-e) arranged to direct portions of a radiation beam to desired locations in a pupil plane (PP); wherein the method comprises allocating different reflective elements of the array to direct radiation to different locations in the illumination mode by:

   determining a desired power spectral density function of radiation directed by the array of reflective elements to the illumination mode, the desired power spectral density function including a cutoff frequency;
applying different phases to frequency components of the power spectral density function;
transforming the power spectral density function into a spatial domain signal that varies as a function of positions of the reflective elements; and
using the spatial domain signal to allocate reflective elements that direct radiation to different locations in the illumination mode.

2. The method of claim 1, wherein the illumination mode comprises a plurality of spatially separated illuminated areas, and wherein the different locations to which radiation is directed correspond with the spatially separated illuminated areas.

3. The method of claim 2, wherein the spatially separated illuminated areas of the illumination mode are poles (pole 1-4).

4. The method of any preceding claim, wherein the power spectral density function includes a low frequency cutoff.

5. The method of claim 4, wherein a coherence size is used to determine the low frequency cutoff of the power spectral density function.

6. The method of claim 4 or claim 5, wherein the power spectral density function includes an additional and different low frequency cutoff used for reflective element allocation in an orthogonal direction on the array of reflective elements.

7. The method of any preceding claim, wherein the power spectral density function includes a high frequency cutoff.

8. The method of any preceding claim, wherein transforming the power spectral density function into the spatial domain signal is performed using an inverse Fourier transform.

9. The method of any preceding claim, wherein the different phases applied to the frequency components are random phases.

10. A method of exposing a substrate using a lithographic apparatus, the method comprising:

   providing a beam of radiation using an illumination system;
   using the method of claim 1 to form an illumination mode using the beam of radiation;
   directing the beam of radiation with the illumination mode onto a patterning device to impart the radiation beam with a pattern in its cross-section; and

projecting the patterned radiation beam onto a target portion of a substrate.

11. An illumination system comprising an array (33,50) of individually controllable reflective elements (33a-e) arranged to direct portions of a radiation beam to desired locations in a pupil plane (PP), and further comprising a processor, wherein the processor is configured to allocate different reflective elements of the array to direct radiation to different locations in an illumination mode by:

determining a desired power spectral density function of radiation directed by the array of reflective elements to the illumination mode, the desired power spectral density function including a cutoff frequency;

applying different phases to frequency components of the power spectral density function;

transforming the power spectral density function into a spatial domain signal that varies as a function of positions of the reflective elements; and

using the spatial domain signal to allocate reflective elements that direct radiation to different locations in the illumination mode.

12. The illumination system of claim 11, wherein the illumination mode comprises a plurality of spatially separated illuminated areas, and wherein the different locations to which radiation is directed correspond with the spatially separated illuminated areas.

13. The illumination system of claim 11 or claim 12, wherein the power spectral density function includes a low frequency cutoff.

14. The illumination system of claim 13, wherein a coherence size is used to determine the low frequency cutoff of the power spectral density function.

15. The illumination system of claim 13 or claim 14, wherein the power spectral density function includes an additional and different low frequency cutoff used for reflective element allocation in an orthogonal direction on the array of reflective elements.

**Fig. 1**

**Fig. 2**

**Fig. 3**

Fig. 4

**Fig. 5**

Fig. 6

Fig. 7

Fig. 8

Fig. 9

Europäisches
Patentamt

European
Patent Office

Office européen
des brevets

# EUROPEAN SEARCH REPORT

**Application Number**

EP 25 15 2911

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2017/315450 A1 (MULDER HEINE MELLE [NL] ET AL) 2 November 2017 (2017-11-02)<br>* abstract *<br>* figures 10,11 *<br>* paragraphs [0002], [0073] - [0078] *<br>----- | 1-15 | INV.<br>G03F7/00 |
| A | DE 10 2012 208521 A1 (ZEISS CARL SMT GMBH [DE]) 27 June 2013 (2013-06-27)<br>* abstract *<br>* figures 16-20 *<br>* paragraphs [0001], [0101] - [0109] *<br>----- | 1-15 | |
| A | US 2008/239268 A1 (MULDER HEINE MELLE [NL] ET AL) 2 October 2008 (2008-10-02)<br>* abstract *<br>* figures 12,13 *<br>* paragraphs [0001], [0081] - [0099] *<br>----- | 1-15 | |

**TECHNICAL FIELDS SEARCHED (IPC)**

G03F

The present search report has been drawn up for all claims

| Place of search | Date of completion of the search | Examiner |
|---|---|---|
| Munich | 9 July 2025 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 2911

This annex lists the patent family members relating to the patent documents cited in the above-mentioned European search report.
The members are as contained in the European Patent Office EDP file on
The European Patent Office is in no way liable for these particulars which are merely given for the purpose of information.

09-07-2025

| Patent document cited in search report | Publication date | Patent family member(s) | | Publication date |
|---|---|---|---|---|
| US 2017315450 A1 | 02-11-2017 | US | 2009033902 A1 | 05-02-2009 |
| | | US | 2016116848 A1 | 28-04-2016 |
| | | US | 2017315450 A1 | 02-11-2017 |
| DE 102012208521 A1 | 27-06-2013 | NONE | | |
| US 2008239268 A1 | 02-10-2008 | CN | 101276154 A | 01-10-2008 |
| | | CN | 102122117 A | 13-07-2011 |
| | | EP | 1975724 A1 | 01-10-2008 |
| | | EP | 2328028 A1 | 01-06-2011 |
| | | JP | 4712062 B2 | 29-06-2011 |
| | | JP | 5537455 B2 | 02-07-2014 |
| | | JP | 2008258605 A | 23-10-2008 |
| | | JP | 2011109128 A | 02-06-2011 |
| | | KR | 20080089198 A | 06-10-2008 |
| | | SG | 146599 A1 | 30-10-2008 |
| | | TW | 200900874 A | 01-01-2009 |
| | | US | 2008239268 A1 | 02-10-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B